## Europäisches Patentamt
## European Patent Office
## Office européen des brevets

(19)

(11) Veröffentlichungsnummer: **0 244 743 B1**

(12) **EUROPÄISCHE PATENTSCHRIFT**

(45) Veröffentlichungstag der Patentschrift: **18.12.91**

(51) Int. Cl.5: **H03K 17/945**

(21) Anmeldenummer: **87106191.7**

(22) Anmeldetag: **29.04.87**

(54) **Zweidraht-Schalter.**

(30) Priorität: **03.05.86 DE 3615052**

(43) Veröffentlichungstag der Anmeldung:
**11.11.87 Patentblatt 87/46**

(45) Bekanntmachung des Hinweises auf die
Patenterteilung:
**18.12.91 Patentblatt 91/51**

(84) Benannte Vertragsstaaten:
**DE FR GB**

(56) Entgegenhaltungen:
**DE-A- 2 623 345**
**DE-A- 2 939 250**
**US-A- 2 972 685**

**TECHNISCHE RUNDSCHAU, Band 64, Nr. 1, 7. Januar 1972, Seiten 26,27; G. LOHRMANN: "Vierschichtdioden , Thyristoren, Diacs und Triacs"**

(73) Patentinhaber: **Gebhard Balluff Fabrik feinmechanischer Erzeugnisse GmbH & Co.**
**Gartenstrasse 21**
**W-7303 Neuhausen a.d.F.(DE)**

(72) Erfinder: **Kammerer, Heinz**
**Achalmstrasse 29**
**W-7302 Ostfildern/Nellingen(DE)**
Erfinder: **Dolderer, Peter**
**Hindenburgstrasse 32,**
**W-7300 Esslingen(DE)**

(74) Vertreter: **Hoeger, Stellrecht & Partner**
**Uhlandstrasse 14 c**
**W-7000 Stuttgart 1(DE)**

## Beschreibung

Die Erfindung betrifft einen Zweidraht-Schalter zum Anschalten einer Last an eine Wechselspannungsquelle, mit einer im Betrieb eingangsseitig mit der Wechselspannungsquelle verbundenen Brückenschaltung, mit einer auf der Ausgangsseite der Brückenschaltung vorgesehenen Halbleiterschaltung, die eingangsseitig durch einen Initiator steuerbar ist und ausgangsseitig eine in Abhängigkeit von dem Betriebszustand des Initiators leitend steuerbare Halbleiter-Schaltstrecke aufweist, und mit einem auf der Eingangsseite der Brückenschaltung befindlichen, bei angeschlossener Last im Lastkreis liegenden steuerbaren Halbleiterbauelement, dessen Steuerelektrode in einem die Halbleiter-Schaltstrecke enthaltenden Steuerstromkreis liegt.

Ein derartiger Zweidraht-Schalter ist aus der Firmendruckschrift "Siemens Components 23 (1985), Seite 81, bekannt und enthält als steuerbares Halbleiterbauelement einen Triac. Dieser Triac liegt im Betrieb das heißt, wenn an die beiden Anschlüsse des Zweidraht-Schalters extern eine Wechselspannungsquelle und eine Last, insbesondere die Erregerwicklung eines Relais, angeschlossen sind, in Serie zu der Last und der Wechselspannungsquelle im Lastkreis des Schalters.

Es ist ein Vorteil dieses bekannten Zweidraht-Schalters, daß über dem Triac nur noch eine Spannung von etwa 1 V abfällt, während bei der bis dahin günstigsten Schaltung mit einem Thyristor auf der Ausgangsseite der Brücke mit einer Restspannung von mindestens 4 bis 5 V gerechnet werden mußte, da bei dieser Schaltung außer dem Thyristor stets zwei Dioden des Brückengleichrichters im Lastkreis liegen. Andererseits wird dieser Vorteil bei der bekannten Schaltung nur dadurch möglich, daß auf der Ausgangsseite der Brückenschaltung die Schaltstrecke eines für eine hohe Spannung geeigneten Transistors liegt.

Aus der DE-OS 33 20 975 ist ferner ein Zweidraht-Schalter bekannt, bei dem auf der Ausgangsseite der Brückenschaltung eine der Erzeugung einer relativ niedrigen Hilfsspannung für die Halbleiterschaltung dienende Hilfsspannungsquelle vorgesehen ist. Bei dieser bekannten Schaltung liegt auf der Ausgangsseite der Halbleiterbrücke ein spannungsfester Transistor, über dessen Schaltstrecke beim Schließen des Lastkreises der Laststrom fließt, was den Nachteil mit sich bringt, daß auch die Dioden der Brückenschaltung wieder im Lastkreis liegen, so daß sich im Lastkreis ein höherer Spannungsabfall ergibt als bei dem oben erläuterten Zweidraht-Schalter mit einem Triac auf der Eingangsseite der Brückenschaltung.

Ausgehend vom vorstehend diskutierten Stand der Technik liegt der Erfindung die Aufgabe zugrunde, bei einem Zweidraht-Schalter mit auf der Ausgangsseite der Brückenschaltung liegender Hilfsspannungsquelle bei minimalem Bauteileaufwand eine niedrige Restspannung im Lastkreis zu erreichen.

Diese Aufgabe wird gemäß der Erfindung dadurch gelöst, daß mit der Ausgangsseite der Brückenschaltung eine der Erzeugung einer relativ niedrigen pulsierenden Gleichspannung als Hilfsspannung dienende Hilfsspannungsquelle verbunden ist, durch die ein als Ladungsspeicher dienender Kondensator aufladbar ist, und daß in den Steuerstromkreis zwischen die Steuerelektrode des steuerbaren Halbleiterbauelements und die Halbleiter-Schaltstrecke die Reihenschaltung eines bei einer vorgegebenen Mindestspannung über dem Kondensator leitend steuerbaren Schwellwertelements und einer Diode eingefügt ist.

Es ist ein wichtiger Vorteil des Zweidraht-Schalters gemäß der Erfindung, daß im Lastkreis eine sehr niedrige Restspannung erreicht wird, da der Laststrom nur über das als Schalter dienende steuerbare Halbleiter-Bauelement fließt und nicht über die Dioden der Brückenschaltung. Außerdem muß auch die Brückenschaltung nur für Ströme von einigen Milliampere ausgelegt werden. Gleichzeitig wird die hohe Spannung auf der Eingangsseite der Brücke von der steuerbaren Halbleiter-Schaltstrecke auf der Ausgangsseite der Brücke durch die in Reihe zu dem Schwellwertelement liegende Diode ferngehalten, so daß diese Schaltstrecke die Kollektor-Emitter-Strecke eines Transistors sein kann, der kein Hochspannungs-Transistor ist, sondern lediglich für die relativ niedrige Hilfsspannung ausgelegt werden muß.

Vorzugsweise ist als Schwellwertelement eines der folgenden Elemente vorgesehen:
eine Z-Diode, eine Trigger-Diode, ein Diac. insbesondere eine Z-Diode, da Z-Dioden mit eng gestaffelten Schwellwertspannungen als handelsübliche Bauelemente preiswert zur Verfügung stehen.

Das steuerbare Halbleiter-Bauelement auf der Eingangsseite der Brücke kann gemäß einer ersten vorteilhaften Ausführungsform eines Zweidraht-Schalters gemäß der Erfindung ein Thyristor sein, zu welchem ein zweiten Thyristor antiparallel geschaltet ist, wobei die Steuerelektrode des weiteren Thyristors über eine weitere Diode mit dem Verbindungspunkt des Schwellwertelements und der dem ersten Thyristor zugeordneten Diode verbunden ist, derart, daß die beiden Dioden, bezogen auf den Verbindungspunkt, in derselben Richtung gepolt sind.

Es ist ein Vorteil dieser Schaltungsvariante, daß entsprechend spannungsfeste und hochbelastbare Thyristoren vergleichsweise billig sind und nur einen geringen Platzbedarf haben und außerdem nur relativ geringe Steuer-und Halteströme benötigen.

In weiterer Ausgestaltung des erfindungsgemäßen Zweidraht-Schalters besteht ferner die Möglichkeit, als steuerbares Halbleiter-Bauelement einen Transistor zu verwenden, zu dem ein zweiter Transistor antiparallel geschaltet ist, wobei die Basis des weiteren Transistors über eine weitere Diode mit dem Verbindungspunkt des Schwellwertelements und der dem ersten Transistor zugeordneten Diode verbunden ist, derart, daß die beiden Dioden, bezogen auf den Verbindungspunkt, in derselben Richtung gepolt sind und wobei außerdem im Kollektoranschluß jedes Transistors jeweils eine dem Verpolungsschutz dienende Diode vorgesehen ist.

Weitere Einzelheiten und Vorteile der Erfindung werden nachstehend anhand von Zeichnungen noch näher erläutert. Es zeigen:

Fig. 1    ein Schaltbild, teilweise in Form eines Blockschaltbildes, eines Zweidraht-Schalters gemäß der Erfindung;

Fig. 1a    einen Ausschnitt des Schaltbildes gemäß Fig. 1 mit den Stompfaden für die Ströme in Steuerkreis und im Lastkreis bei Vorliegen einer positiven Halbwelle einer Wechselspannung an den Schalteranschlüssen;

Fig. 1b    einen Ausschnitt des Schaltbildes gemäß Fig. 1 mit den Strompfad für die Ströme in Steuerkreis und im Lastkreis bei Vorliegen einer negativen Halbwelle einer Wechselspannung an den Schalteranschlüssen;

Fig. 2    ein Schaltbild eines weiteren Zweidraht-Schalters gemäß der Erfindung; und

Fig. 3    ein Teil-Schaltbild zweier weiterer Zweidraht-Schalter gemäß der Erfindung.

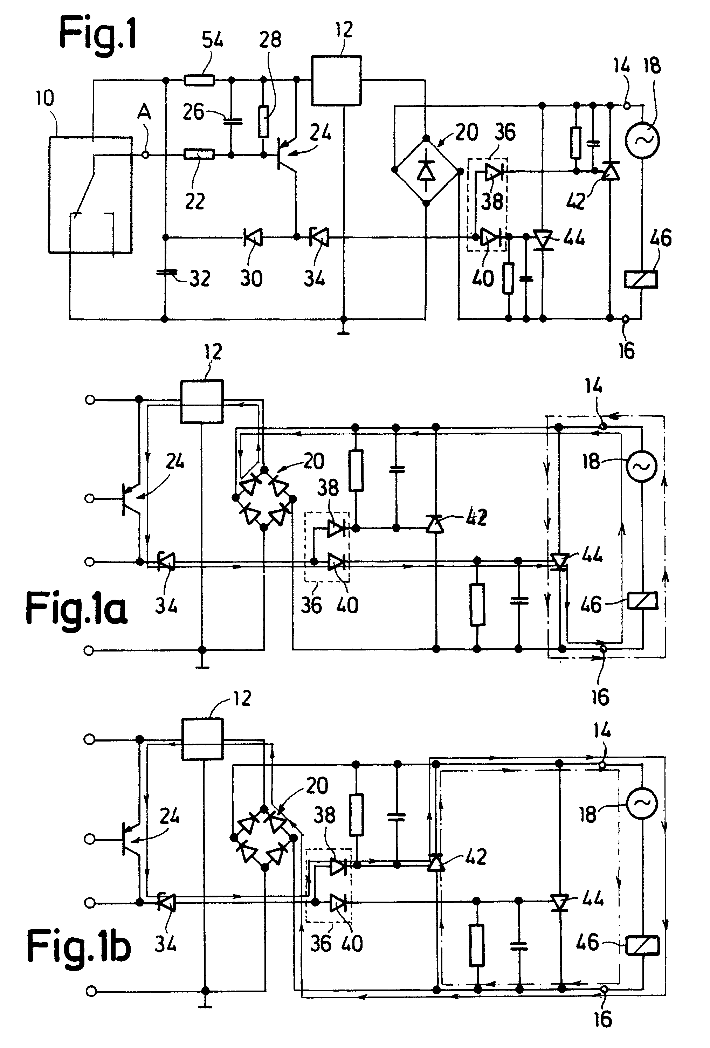

Im einzelnen umfaßt die Schaltung gemäß Fig. 1 einen Initiator 10, beispielsweise einen üblichen induktiven Näherungsschalter, wie er von der Anmelderin unter der Typenbezeichnung BES 517-300 S 141 in den Handel gebracht wird.

Der Initiator 10 ist einerseits mit Bezugspotential und andererseits mit dem Ausgang einer Hilfsspannungsquelle 12 verbunden, an dem eine stabilisierte Speisespannung von beispielsweise etwa +10 V zur Verfügung steht. Eine derartige Hilfsspannungsquelle ist beispielsweise in der DE-OS 33 20 975 beschrieben. Bei der dort beschriebenen Hilfsspannungsquelle wird die Hilfsspannung durch einen Phasenanschnitt der gleichgerichteten Wechselspannung erhalten, die an den externen Anschlüssen 14, 16 des Zweidraht-Schalters anliegt. Dabei erfolgt die Gleichrichtung der aus einer Wechselspannungsquelle 18 stammenden Wechselspannung wie beim Ausführungsbeispiel mittels einer Gleichrichterbrücke 20, welche in konventioneller Weise aus vier Dioden aufgebaut ist, wie dies in Fig. 1a und 1b dargestellt ist.

Der Initiator 10 besitzt einen Ausgang A, an dem je nach dem Schaltzustand des schematisch angedeuteten Schalters im wesentlichen die Bezugsspannung oder die positive Speisespannung anliegt. Der Ausgang A des Initiators 10 ist über einen Widerstand 22 mit der Basis eines Transistors 24 verbunden, dessen Emitter mit dem Ausgang der Hilfsspannungsquelle 12 verbunden ist, wobei zwischen Emitter und Basis in üblicher Weise eine Emitter-Basis-Kapazität 26 und ein Emitter-Basis-Widerstand 28 liegen.

Der Emitter des Transistors 24 ist einerseits mit dem Ausgang der Hilfsspannungsquelle 12 und andererseits über einen Widerstand 54 mit der einen Platte eines Kondensators 32 verbunden, dessen andere Platte an Bezugspotential liegt und der als Ladungsspeicher zur Versorgung des Initiators 10 dient, wenn auf der Eingangsseite der Brücke 20 keine Spannung anliegt, wie dies weiter hinten noch näher erläutert wird. Der Kollektor des Transistors 24 ist einerseits über eine Diode 30 mit der vom Bezugspotential abgewandten Platte des Kondensators 32 verbunden und andererseits über eine Z-Diode 34 mit dem Eingang einer Entkoppelungsschaltung 36 verbunden. Die Entkoppelungsschaltung 36 besteht beim Ausführungsbeispiel aus zwei Dioden 38, 40, deren Anoden miteinander und mit dem Eingang der Entkoppelungsschaltung 36 verbunden sind und deren Kathoden jeweils mit der Steuerelektrode einer steuerbaren Diode, nämlich eines Thyristors 42 bzw. 44, verbunden sind. Die beiden Thyristoren 42, 44 liegen bei dem erfindungsgemäßen Schalter antiparallel zueinander zwischen den externen Anschlüssen 14, 16. wobei parallel zur Steuerelektroden/Kathoden-Strecke jeweils der übliche Gate/Kathoden-Widerstand bzw. die Gate/Kathoden-Kapazität liegen.

Gemäß Fig. 1 liegt schließlich in Serie zu der Wechselspannungsquelle 18 eine Last 46, welche entsprechend dem hauptsächlichen Einsatzzweck von Zweidraht-Schaltern gemäß der Erfindung als Erregerwicklung eines Relais dargestellt ist.

Die in Fig. 1 gezeigte Schaltung arbeitet zur Erzeugung der Hilfsspannung in an sich bekannter Weise mit einem Phasenanschnitt, was im vorliegenden Fall bedeutet, daß die beiden Thyristoren 42, 44 zu Beginn jeder Halbwelle der Wechselspannung für ein vorgegebenes Zeitintervall gesperrt bleiben, und zwar so lange, bis auf der Ausgangsseite der Hilfsspannungsquelle 12 eine Spannung erreicht ist, die der Schaltschwelle der Z-Diode 34 entspricht.

Wenn der Transistor 24 durch den Pegel am Ausgang des Initiators 10 leitend gesteuert ist und wenn gleichzeitig am Ausgang der Wechselspannungsquelle 18 eine positive Halbwelle ansteht, dann fließt gemäß Fig. 1a, sobald der Kondensator 32 über die Schaltstrecke des Transistors 24 und die Diode 30 aufgeladen und die Schaltschwelle der Z-Diode 34 erreicht ist, ein in Form einer durchgezogenen Linie angedeuteter Steuerstrom von dem Anschluß 14 über die Gleichrichterbrücke 20, die Hilfsspannungsquelle 12, die Emitter/Kollektor-Strecke des Transistors 24, die Z-Diode 34 und die Diode 40 zur Steuerelektrode des Thyristors 44 und von dort über die Kathode des Thyristors 44 und die Last 46 zurück zum negativen Anschluß der Wechselspannungsquelle 18. Hierdurch wird der Thyristor 44 leitend gesteuert, so daß nunmehr über die Serienschaltung des Thyristors 44, der Last 46 und der Wechselspannungsquelle 18, die gemeinsam den Lastkreis bilden, ein Laststrom fließen kann, der als strichpunktierte Linie angedeutet ist, wobei die Stromrichtung ähnlich wie beim Steuerstrom durch Pfeile angedeutet ist. Sobald der Thyristor 44 leitend gesteuert wird, bricht die Spannung auf der Eingangsseite der Brückenschaltung 20 bis auf die geringe Restspannung über der Schaltstrecke des Thyristors 44 zusammen, so daß auch die Hilfsspannungsquelle 12 keine Ausgangsspannung mehr liefern kann. Die Speisespannung für den Initiator 10 wird nunmehr während des Rests der laufenden Halbwelle von dem zuvor aufgeladenen Kondensator 32 geliefert. Solange auf der Eingangsseite der Brückenschaltung 20 dagegen eine Spannung ansteht und der Transistor 24 aufgrund eines entsprechenden Ausgangssignals des Initiators 10 gesperrt ist, dient der Widerstand 54 dazu, für den Initiator 10 einen eingeprägten Strom zu erzeugen. Die Diode 30 dient dem Zweck der Entkoppelung zwischen der Stromversorgung des Initiators 10 und der Thyristoransteuerung.

In entsprechender Weise wird bei einer negativen Halbwelle der Wechselspannungsquelle 18 der Thyristor 42 leitend gesteuert, wobei der Steuerstrom und der Laststrom längs der in Fig. 1b angedeuteten Pfade fließen.

Man erkennt, daß bei dem Zweidraht-Schalter gemäß der Erfindung bei eingeschaltetem Lastkreis jeweils nur noch die Anoden/Kathoden-Strecke eines einzigen Thyristors im Lastkreis liegt. Außer an der Last tritt also ein Spannungsabfall nur an der Schaltstrecke eines einzigen Thyristors auf, wobei dieser Spannungsabfall etwa 1 V beträgt. Dabei ist es vorteilhaft, daß die beiden antiparallel geschalteten Thyristoren 42, 44 vergleichsweise preiswerte handelsübliche Bauelemente mit geringem Platzbedarf sind und daß der Schalttransistor 24 durch die Dioden 38, 40 der Entkoppelungsschaltung von der hohen Wechselspannung entkoppelt ist und nur die relativ niedrige Spannung von etwa 10 V am Ausgang der Hilfsspannungsquelle 12 schalten muß.

Voraussetzung für das Funktionieren der Schaltung ist es dabei allerdings, daß die Dioden 38, 40 eine für die Wechselspannung ausreichende Spannungsfestigkeit besitzen. Diese Forderung wird von vielen relativ preiswerten und kleinen, handelsüblichen Halbleiterdioden erfüllt.

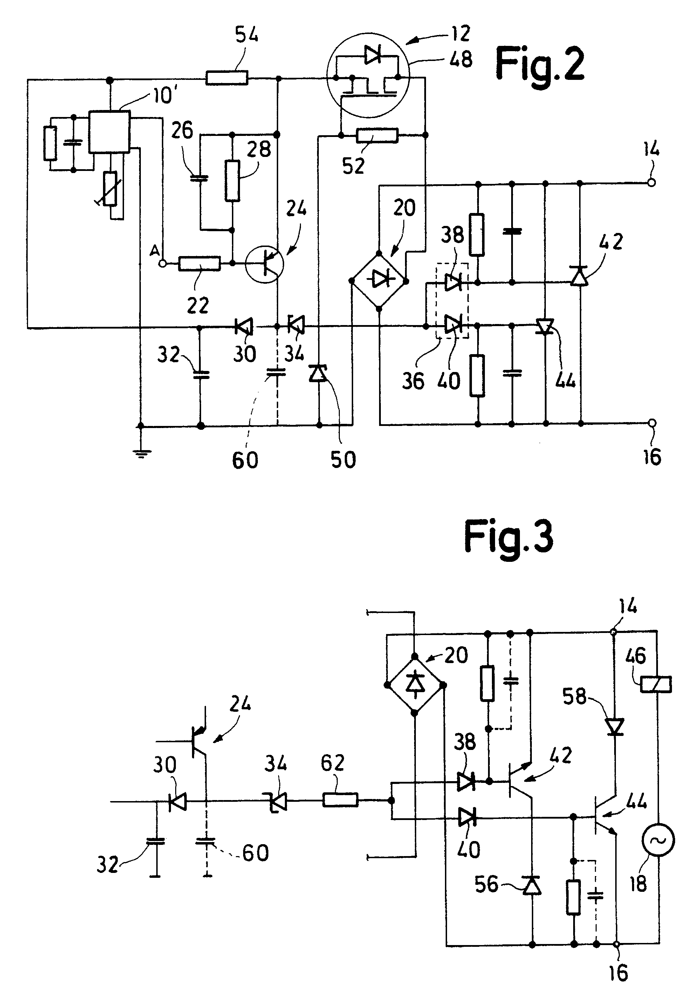

Die in Fig. 2 gezeigte Schaltung eines Zweidraht-Schalters gemäß der Erfindung entspricht hinsichtlich der Ausbildung des Lastkreises und seiner Ansteuerung vollständig der Schaltung gemäß Fig. 1. Der in Fig. 1 lediglich schematisch gezeigte Initiator 10 ist jedoch durch eine handelsübliche integrierte Schaltung 10' des Typs TDE 0160 der Firma Thomson-CSF ersetzt, welcher mit der entsprechenden äußeren Beschaltung versehen ist. Weiterhin ist in Fig. 2 der Spannungsregler bzw. die Hilfsspannungsquelle 12, die in Fig. 1 nur als Block dargestellt ist, detailliert dargestellt. Man erkennt, daß die Hilfsspannungsquelle 12 als Hauptelement einen Feldeffekt-Transistor 48 aufweist, dessen Drain/Source-Strecke zwischen der Gleichrichterbrücke 20 und dem Emitter des Transistors 24 liegt und dessen Gate-Elektrode mit dem anderen - ausgangsseitigen - Anschluß der Brücke 20 über eine Z-Diode 50 verbunden ist. Außerdem ist parallel zur Gate/Drain-Strecke des Transistors 48 ein Widerstand 52 vorgesehen.

Bei der in Fig. 2 gezeigten Hilfsspannungsquelle wird der Transistor 48 auf der Ausgangsseite der Brücke 20 bei jeder Halbwelle, zumindest für die Dauer des Phasenanschnitts, leitend gesteuert, wobei die Z-Diode 50 die an seiner Gate-Elektrode wirksame Spannung auf einen vorgegebenen Wert begrenzt. Auf diese Weise erhält man auf der Ausgangsseite des Transistors 48 eine pulsierende Gleichspannung mit einer relativ niedrigen Amplitude von beispielsweise etwa 10 V, aus der mit Hilfe des Widerstandes 54 ein im wesentlichen konstanter Strom (eingeprägter Strom) für die Speisung der integrierten Schaltung 10' gewonnen wird.

In Fig. 3 ist eine weitere Variante eines ZweidrahtSchalters gemäß der Erfindung dargestellt, und zwar nur der auf der Eingangsseite der Brücke befindliche Schaltungsteil mit zugehörigen Elementen des Steuerstromkreises. Die Thyristoren 42,44 der Schaltungen gemäß Fig. 1 und 2 sind in Fig. 3 durch Transistoren 42,44 ersetzt, die durch Dioden 56,58 in ihrem Kollektoranschluß gegen eine Verpolung geschützt sind. Ferner ist zwischen die Z-Diode 34 und die Dioden 38,40 ein Basis-Vorwiderstand 62 eingefügt. Im übrigen ist der Zweidraht-Schalter gemäß Fig. 3 auf der Ausgangsseite der Brücke im wesentlichen ebenso ausgebildet wie dies anhand von Fig. 1 erläutert wurde.

Ergänzend ist bezüglich der Schaltungen gemäß Fig. 2 und 3 noch darauf hinzuweisen, daß dort zwischen dem Kollektor des Transistors 24 und Bezugspotential ein weiterer Kondensator 60 mit gestrichelten Linien angedeutet ist. Dies soll zeigen, daß für den Steuerstromkreis ein separater Kondensator vorgesehen sein kann, wenn dies aus technischen Gründen wünschenswert ist. Normalerweise genügt jedoch ein einziger Kondensator - bei den Ausführungsbeispielen der Kondensator 32 - als Ladungsspeicher für die Hilfsspannung und als Kondensator für den Steuerstromkreis.

## Patentansprüche

1. Zweidraht-Schalter zum Anschalten einer Last (46) an eine Wechselspannungsquelle (18), mit einer im Betrieb eingangsseitig mit der Wechselspannungsquelle verbundenen Gleichrichter-Brückenschaltung (20), mit einer auf der Ausgangsseite der Brückenschaltung vorgesehenen Halbleiterschaltung, die eingangsseitig durch einen Initiator (10) steuerbar ist und ausgangsseitig eine in Abhängigkeit von dem Betriebszustand des Initiators leitend steuerbare Halbleiter-Schaltstrecke (24) aufweist, und mit einem auf der Eingangsseite der Brückenschaltung befindlichen, bei angeschlossener Last im Lastkreis liegenden steuerbaren Halbleiterbauelement (42,44), dessen Steuerelektrode in einem die Halbleiter-Schaltstrecke enthaltenden Steuerstromkreis liegt, dadurch **gekennzeichnet,** daß mit der Ausgangsseite der Brückenschaltung (20) eine der Erzeugung einer im Vergleich zur Wechselspannung relativ niedrigen pulsierenden Gleichspannung als Hilfsspannung dienende Hilfsspannungsquelle (12) verbunden ist, durch die ein als Ladungsspeicher dienender Kondensator (32) aufladbar ist, und daß in den Steuerstromkreis zwischen die Steuerelektrode des steuerbaren Halbleiterbauelements (42,44) und die Halbleiter-Schaltstrecke die Reihenschaltung eines bei einer vorgegebenen Mindestspannung über dem Kondensator (32) leitend steuerbaren Schwellwertelements (34) und einer Diode (38, 40) eingefügt ist.

2. Zweidraht-Schalter nach Anspruch 1, dadurch gekennzeichnet, daß als Schwellwert-Element eines der folgenden Elemente vorgesehen ist: eine Z-Diode (34), eine Trigger-Diode, ein Diac.

3. Zweidraht-Schalter nach Anspruch 1 oder 2, dadurch gekennzeichnet, daß das steuerbare Halbleiter Bauelement ein Thyristor (42) ist, zu welchem ein zweiter Thyristor (44) antiparallel geschaltet ist, und daß die Steuerelektrode des weiteren Thyristors (44) über eine weitere Diode (40) mit dem Verbindungspunkt des Schwellwertelements (34) und der dem ersten Thyristor (42) zugeordneten Diode (38) verbunden ist, derart, daß die beiden Dioden (38,40), bezogen auf den Verbindungspunkt, in derselben Richtung gepolt sind.

4. Zweidraht-Schalter nach Anspruch 3, dadurch gekennzeichnet, daß der Kondensator (32) gleichzeitig als Ladungsspeicher zur Speisung des Initiators (10) vorgesehen ist.

5. Zweidraht-Schalter nach Anspruch 1 oder 2, dadurch gekennzeichnet, daß das steuerbare Halbleiter-Bauelement als Transistor (42) mit einer dem Verpolungsschutz dienenden Diode (56) im Kollektoranschluß ausgebildet ist, zu dem ein zweiter Transistor (44) mit einer dem Verpolungsschutz dienenden Diode (58) im Kollektoranschluß antiparallel geschaltet ist, und daß die Basis des weiteren Transistors (44) über eine weitere Diode (40) mit dem Verbindungspunkt des Schwellwertelements (34) und der dem ersten Transistor(42) zugeordneten Diode (38) verbunden ist, derart, daß die beiden Dioden (38,40),bezogen auf den Verbindungspunkt, in derselben Richtung gepolt sind.

## Claims

1. Two-wire switch for connecting a load (46) to an AC voltage source (18), comprising a bridge rectifier circuit (20) connected in the operating state on the input side to the AC voltage source, a semiconductor circuit provided on the output side of the bridge rectifier circuit, said semiconductor circuit being controllable on the input side by an initiator (10) and having on the output side a semiconductor switching path (24) capable of being brought into the conductive state in response to the operating state of the initiator, and also comprising a controllable semiconductor component (42, 44) on the input side of the bridge rectifier circuit and located in the load circuit when the load is in the connected state, the control electrode of said component being located in a control current circuit including the semiconductor switching path, characterized in that an auxiliary voltage source (12) serving to generate a pulsating DC voltage as auxiliary voltage, which is relatively low in comparison with the AC voltage, is connected to the output side of the bridge rectifier circuit (20) and a capacitor (32) serving as charge storage device is chargeable by said auxiliary voltage source, and that the series connection of a diode (38, 40) and a threshold element (34) capable of being brought into the conducting state at a predetermined minimum voltage across the capacitor (32) is inserted into the control current circuit between the control electrode of the controllable semiconductor component (42, 44) and the semiconductor switching path.

2. Two-wire switch as defined in claim 1, characterized in that one of the following elements is provided as threshold element:
a Zener diode (34), a triggering diode, a diac.

3. Two-wire switch as defined in claim 1 or 2, characterized in that the controllable semiconductor component is a thyristor (42) having a second thyristor (44) connected in antiparallel relationship thereto, and that the control electrode of the additional thyristor (44) is connected via an additional diode (40) with the connection point of the threshold element (34) and the diode (38) associated with the first thyristor (42) such that the two diodes (38, 40) are poled in the same direction in relation to the connection point.

4. Two-wire switch as defined in claim 3, characterized in that the capacitor (32) is provided simultaneously as charge storage means for supplying the initiator (10).

5. Two-wire switch as defined in claim 1 or 2, characterized in that the controllable semiconductor component is designed as a transistor (42) having a diode (56) at the collector terminal serving as protection against incorrect poling, a second transistor (44) having a diode (58) at the collector terminal serving as protection against incorrect poling being connected in antiparallel relationship to said transistor, and that the base of the additional transistor (44) is connected via an additional diode (40) to the connection point of the threshold element (34) and the diode (38) associated with the first transistor (42) such that the two diodes (38, 40) are poled in the same direction in relation to the connection point.

**Revendications**

1. Commutateur à deux fils pour le branchement d'une charge (46) à une source de tension alternative (18), comportant un circuit redressant en pont (20) relié en fonctionnement, côté entrée, à la source de tension alternative, un circuit à semi-conducteur prévu sur le côté sortie du circuit en pont, pouvant être commandé côté entrée, par un commutateur d'amorçage (10) et présentant côté sortie, un circuit de commutation à semi-conducteur (24) susceptible d'être rendu passant en fonction de l'état de fonctionnement du commutateur d'amorçage, ainsi qu'un composant à semi-conducteur (42, 44) pouvant être commandé, situé sur le côté entrée du circuit en pont, se trouvant dans le circuit de la charge lorsque celle-ci est raccordée, et dont l'électrode de commande se trouve dans un circuit de courant de commande renfermant le circuit de commutation à semi-conducteur, caractérisé en ce qu'à la sortie du circuit en pont (20) est reliée une source de tension auxiliaire (12) destinée à produire, en tant que tension auxiliaire, une tension continue pulsée relativement faible en comparaison de la tension alternative, et grâce à laquelle peut être chargé un condensateur (32) faisant office d'accumulateur de charge, et en ce que dans le circuit de courant de commande, entre l'électrode de commande du composant à semi-conducteur (42, 44) susceptible d'être commandé et le circuit de commutation à semi-conducteur, est inséré le montage en série d'un élément à valeur de seuil (34) susceptible d'être rendu passant pour une tension minimum prédéfinie, par le condensateur (32), et d'une diode (38, 40).

2. Commutateur à deux fils selon la revendication 1, caractérisé en ce qu'en guise d'élément à valeur de seuil, il est prévu un des éléments suivants:
une diode Zener (34), une diode à déclenchement, un diac.

3. Commutateur à deux fils selon la revendication 1 ou 2, caractérisé en ce que le composant à semi-conducteur susceptible d'être commandé est un thyristor (42) formant un montage antiparallèle avec un second thyristor (44), et en ce que l'électrode de commande de cet autre thyristor (44) est reliée par l'intermédiaire d'une autre diode (40), au point de jonction de l'élément à valeur de seuil (34) et de la diode (38) associée au premier thyristor (42), de telle sorte que les deux diodes (38,40) soient polarisées dans le même sens, en se référant au point de jonction.

4. Commutateur à deux fils selon la revendication 3, caractérisé en ce que le condensateur (32) est prévu simultanément comme accumulateur de charge pour l'alimentation du commutateur d'amorçage (10).

5. Commutateur à deux fils selon la revendication 1 ou 2, caractérisé en ce que le composant à semi-conducteur est réalisé sous la forme d'un transistor (42) comportant une diode (56) au collecteur pour la protection contre l'inversion de polarisation, et formant un montage antiparallèle avec un second transistor (44) comportant une diode (58) au collecteur pour la protection contre l'inversion de polarisation, et en ce que la base de cet autre transistor (44) est reliée par l'intermédiaire d'une autre diode (40), au point de jonction de l'élément à valeur de seuil (34) et de la diode (38) associée au premier transistor (42), de telle sorte que les deux diodes (38,40) soient polarisées dans le même sens, en se référant au point de jonction.

Fig.1

Fig.1a

Fig.1b

# Fig.2

# Fig.3